(19) Europäisches Patentamt
European Patent Office
Office européen des brevets

(11) Veröffentlichungsnummer: **0 262 479 B1**

(12) **EUROPÄISCHE PATENTSCHRIFT**

(45) Veröffentlichungstag der Patentschrift: **24.04.91**

(51) Int. Cl.5: **H04Q 3/52, H03K 17/693**

(21) Anmeldenummer: **87113203.1**

(22) Anmeldetag: **09.09.87**

(54) **Breitbandsignal-Koppeleinrichtung.**

(30) Priorität: **17.09.86 DE 3631634**

(43) Veröffentlichungstag der Anmeldung:
**06.04.88 Patentblatt 88/14**

(45) Bekanntmachung des Hinweises auf die
Patenterteilung:
**24.04.91 Patentblatt 91/17**

(84) Benannte Vertragsstaaten:
**AT BE CH DE FR GB IT LI NL SE**

(56) Entgegenhaltungen:

**PATENT ABSTRACTS OF JAPAN, Band 10,
Nr. 283 (E-440)[2339], 26. September 1986; &
JP-A-61 101 121**

**IBM TECHNICAL DISCLOSURE BULLETIN,
Band 27, Nr. 10B, März 1985, Seiten
6019-6021, New York, US; "Three-port latch"**

(73) Patentinhaber: **Siemens Aktiengesellschaft
Wittelsbacherplatz 2
W-8000 München 2(DE)**

(72) Erfinder: **Hofmann, Rüdiger, Dr.
Fürstenfelder Weg 12
W-8031 Gilching(DE)**

**Beschreibung**

Neuere Entwicklungen der Fernmeldetechnik führen zu diensteintegrierenden Nachrichtenübertragungs- u. -vermittlungssystemen für Schmalband- und Breitband-Kommunikationsdienste, die als Übertragungsmedium im Bereich der Teilnehmeranschlußleitungen Lichtwellenleiter vorsehen, über die sowohl die Schmalbandkommunikationsdienste, wie insbesondere 64-kbit/s-Digital-Telefonie, als auch Breitbandkommunikationsdienste, wie insbesondere 140-Mbit/s-Bildtelefonie, geführt werden, wobei aber in den Vermittlungsstellen (vorzugsweise gemeinsame Steuereinrichtungen aufweisende) Schmalbandsignal-Koppeleinrichtungen und Breitbandsignal-Koppeleinrichtungen nebeneinander vorgesehen sind (DE-PS 24 21 002).

Im Zusammenhang mit einer Breitbandsignal-Zeitmultiplex-Koppeleinrichtung, deren Koppelpunkte im Zeitmultiplex jeweils für eine Mehrzahl von Verbindungen genutzt werden, ist es bekannt, jeweils zwei Leitungen mit Hilfe eines Gatterelements zu verbinden, das von einer als bistabiles D-Kippglied gebildeten koppelpunktindividuellen Speicherzelle ein- und ausgeschaltet wird, wobei diese koppelpunktindividuelle Speicherzelle, deren Clock-Eingang ein entsprechendes Taktsignal zugeführt wird, in nur einer Koordinatenrichtung, und zwar an ihrem D-Eingang, angesteuert wird (Pfannschmidt: "Arbeitsgeschwindigkeitsgrenzen von Koppelnetzwerken für Breitband-Digitalsignale", Diss., Braunschweig 1978, Bild 6.7, ferner Bild 6.4). In Anbetracht eines bei einer Bitrate von 140 Mbit/s erreichbaren Zeitmultiplexfaktors von etwa 4 bis 8 und der dabei erforderlichen aufwendigen Schaltungstechnologie werden derzeit allerdings zur Vermittlung von Breitbandsignalen reine Raumkoppeleinrichtungen bevorzugt, in denen die über die einzelnen Koppelpunkte durchgeschalteten Verbindungen allein räumlich voneinander getrennt sind.

Eine reine Breitbandsignal-Raumkoppelanordnung kann als mit Eingangsverstärkern und Ausgangsverstärkern versehene Koppelpunktmatrix in C-MOS-Technik ausgebildet sein, in deren Koppelpunkten die Koppelelemente jeweils von einer decodergesteuerten, koppelpunktindividuellen Halte-Speicherzelle gesteuert werden, wobei die Koppelelemente jeweils als C-MOS-Transfergate (C-MOS-Transmissionsgate) ausgebildet sind (ISS'84 Conference Papers 23CI, Fig.9); die koppelpunktindividuellen Halte-Speicherzellen eines reinen Raumkoppelvielfachs können von einem Zeilendecoder und von einem Spaltendecoder her jeweils über eine zeilen-bzw. spaltenindividuelle Ansteuerleitung in zwei Koordinaten angesteuert werden (Pfannschmidt, a.a.O., Bild 6.4).

Es ist weiter (aus Electronics, Dec.15, 1983, p.88/89) in allgemeiner Form bekannt, in einer Breitbandsignal-Koppelpunktmatrix digitale Koppelpunkte in Form von Tristate-Invertern vorzusehen, deren konkrete Realisierung dabei indessen offenbleibt.

Die Erfindung stellt sich nun die Aufgabe, einen Weg aufzuzeigen, wie in einer Breitbandsignal-Koppeleinrichtung Koppelpunkte relativ hoher Arbeitsgeschwindigkeit und geringer Verlustleistung mit relativ geringem Transistoraufwand konkret realisiert werden können.

Die Erfindung betrifft eine Breitbandsignal-Koppeleinrichtung mit einer Koppelpunktmatrix in FET-Technik, deren Koppelelemente jeweils mit einem an seiner Steuerelektrode mit einem Durchschalte-bzw. Sperrsignal beaufschlagten, mit einer Hauptelektrode an die zugehörige Matrixausgangsleitung angeschlossenen Schalter-Transistor gebildet sind; diese Breitbandsignal-Koppeleinrichtung ist erfindungsgemäß dadurch gekennzeichnet, daß die Koppelelemente jeweils einen mit dem Schalter-Transistor eine Serienschaltung bildenden Vorschalt-Transistor aufweisen, der mit seiner Steuerelektrode an die zugehörige Matrixeingangsleitung angeschlossen ist und dessen der Serienschaltung abgewandte Hauptelektrode über einen Abtast-Transistor mit dem einen Anschluß der Betriebsspannungsquelle verbunden ist, mit deren anderen Anschluß die jeweilige Matrixausgangsleitung über einen Vorlade-Transistor verbunden ist, und daß Vorlade-Transistor und Abtast-Transistor gegensinnig zueinander jeweils an ihrer Steuerelektrode mit einem eine Bit-Durchschaltezeitspanne in eine Vorladephase und die eigentliche Durchschaltephase unterteilenden Koppelfeld-Ansteuer-Takt beaufschlagt sind, so daß in jeder Vorphase bei gesperrtem Abtast-Transistor die Matrixausgangsleitung über den Vorlade-Transistor zumindest angenähert auf das an dem genannten anderen Anschluss der Betriebsspannungsquelle herrschende Potential geladen wird.

Die Erfindung bringt den Vorteil mit sich, daß bei der eigentlichen Bitdurchschaltung ggf. stattfindende Umladungen der Matrixausgangsleitung stets von dem dem einen Signalzustand entsprechenden einen Betriebspotential ausgehend in nur einer Umladerichtung vor sich gehen und somit bereits mit einer (dem Überschreiten einer diesem Betriebspotentialwert benachbarten Schwelle entsprechenden) kleinen Umladung - und damit entsprechend schnell - ein eindeutiger Übergang des durchgeschalteten Digitalsignals von dem einen in den anderen Signalzustand verbunden ist. Bei einer Realisierung der Koppelpunktmatrix in C-MOS-Technik erhöht sich im Vergleich mit Koppelpunktmatrizen, deren Koppelelemente mit C-MOS-Transfergates u./o. C-MOS-Invertern gebildet sind, die Arbeitsgeschwindigkeit weiter, wenn in weiterer Ausgestaltung der Erfindung die Schalter-, Vorschalt-und Abtast-Transistoren n-Kanal-Transistoren sind und allenfalls die Vorlade-Transistoren p-Kanal-Transistoren sind;

wegen ihres höheren spezifischen Widerstands eine größere Fläche erfordernde p-Kanal-Transistoren sind so allenfalls nur matrixausgangsleitungsindividuell, jedenfalls aber nicht koppelpunktindividuell vorzusehen, so daß, was bei einer Integration von besonderer Bedeutung ist, die Koppelpunktmatrix mit entsprechend geringem Platzbedarf und mit entsprechend geringen Schaltungskapazitäten zu realisieren ist. Da die Verlustleistung der Koppelpunktmatrix überwiegend auf den Matrixleitungen zu erbringende Ladeleistung ist, verringert sich bei reduzierter kapazitiver Belastung der Matrixausgangsleitungen neben den Umladezeiten auch der Gesamtleistungsbedarf.

Weitere Besonderheiten der Erfindung werden aus der nachfolgenden näheren Erläuterung der Erfindung anhand der Zeichnung ersichtlich. Dabei zeigen

FIG 1 das Schema einer Breitband-Koppeleinrichtung und

FIG 2, FIG 3 und FIG 4 Einzelheiten ihrer schaltungstechnischen Realisierung gemäß der Erfindung;

FIG 5 verdeutlicht Signalverläufe darin.

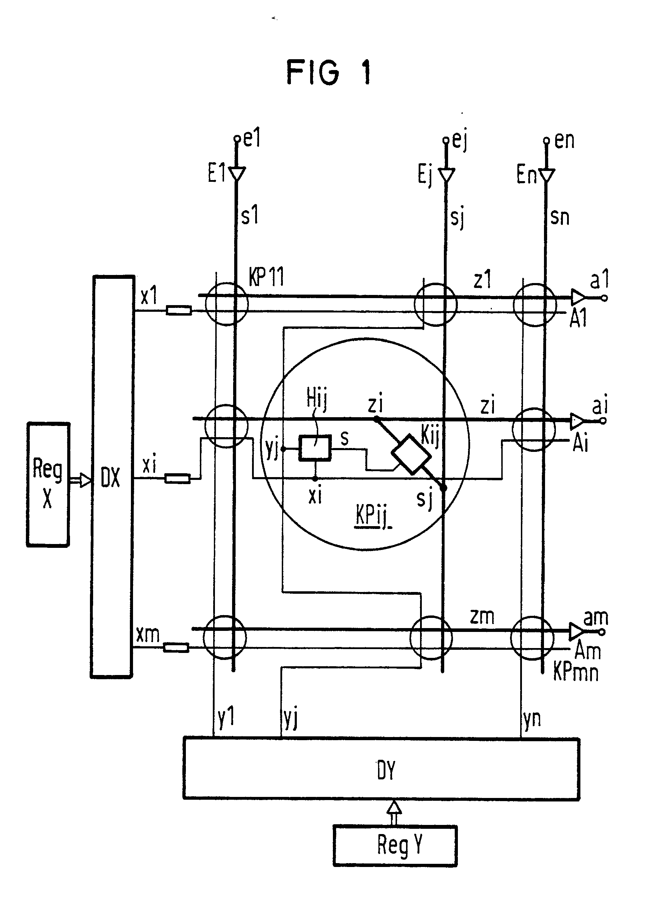

In der Zeichnung FIG 1 ist schematisch in zum Verständnis der Erfindung erforderlichem Umfange eine Breitbandsignal-Koppeleinrichtung skizziert, an deren zu Spaltenleitungen sl...sj...sn einer Koppelpunktmatrix führenden Eingängen el...ej...en Eingangstreiberschaltungen El...Ej...En vorgesehen sind und deren von Zeilenleitungen zl...zi...zm der Koppelpunktmatrix erreichte Ausgänge al...ai...am mit Ausgangsverstärkerschaltungen Al...Ai...Am versehen sind. Die Koppelpunktmatrix weist Koppelpunkte KPII...KPij...KPmn auf, deren Koppelelemente, wie dies beim Koppelpunkt KPij für dessen Koppelelement Kij weiter ins Einzelne gehend angedeutet ist, jeweils von einer koppelpunktindividuellen Halte-Speicherzelle Hij (beim Koppelpunkt KPij) gesteuert sein können, deren Ausgang s zum Steuereingang des jeweiligen Koppelelements (Kij beim Koppelpunkt KPij) führt.

Die Halte-Speicherzellen ... Hij... werden gemäß FIG 1 durch zwei Ansteuerdecoder, nämlich einen Zeilendecoder DX und einen Spaltendecoder DY, über entsprechende Ansteuerleitungen xl...xi...xm; yl...yj...yn in zwei Koordinaten angesteuert.

Dazu mögen, wie dies aus FIG 1 ersichtlich ist, die beiden Ansteuerdecoder DX, DY von Eingangsregistern Reg X, Reg Y her jeweils mit einer einer Matrixreihe (Zeile bzw.Spalte) von Koppelpunkten gemeinsamen Koppelpunktzeilen- bzw. Koppelpunktspalten-Adresse beaufschlagbar sein, auf die hin sie jeweils an der der jeweiligen Koppelpunktreihen-Adresse entsprechenden Ansteuerleitung jeweils ein "1"-Ansteuersignal abgeben. Das Zusammentreffen eines Zeilenansteuersignals "1" und eines Spaltenansteuersignals "1" am Kreuzungspunkt der betreffenden Matrixzeile mit der betreffenden Matrixspalte beim Aufbau einer entsprechenden Verbindung bewirkt dann eine Aktivierung der dort befindlichen Halte-Speicherzelle, beispielsweise der Speicherzelle Hij, mit der Folge, daß das von der betreffenden Halte-Speicherzelle (Hij) gesteuerte Koppelelement, im Beispiel das Koppelelement Kij, leitend wird.

Damit das im Beispiel betrachtete Koppelelement Kij bei einem Abbau der betreffenden Verbindung wieder gesperrt wird, wird wiederum der Ansteuerdecoder DX vom Eingangsregister Reg X mit der betreffenden Zeilenadresse beaufschlagt, so daß der Zeilendecoder DX wiederum auf seiner Ausgangsleitung xi ein Zeilenansteuersignal "1" abgibt, und zugleich wird der Spaltendecoder DY von seinem Eingangsregister Reg Y her beispielsweise mit einer Leeradresse oder mit der Adresse einer Spalte von unbeschalteten Koppelpunkten beaufschlagt, so daß er auf seiner Ausgangsleitung yj ein Spaltenansteuersignal "0" abgibt; das Zusammentreffen von Zeilenansteuersignal "1" und Spaltenansteuersignal "0" bewirkt dann die Rücksetzung der Halte-Speicherzelle Hij mit der Folge, daß das von ihr gesteuerte Koppelelement Kij gesperrt wird.

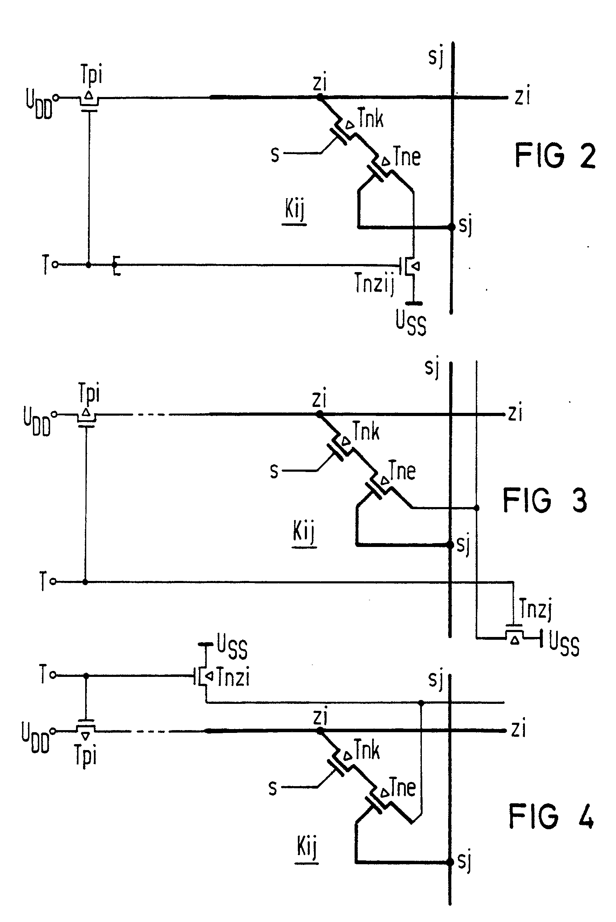

Wie die Koppelelemente ...Kij... schaltungstechnisch realisiert sein können, wird in FIG 2, FIG 3 und FIG 4 verdeutlicht: Die Koppelelemente ...Kij... weisen jeweils einen mit einem Schalter-Transistor Tnk eine Serienschaltung bildenden Vorschalt-Transistor Tne auf, der mit seiner Steuerelektrode an die zugehörige Matrixeingangsleitung (Spaltenleitung) ... sj... angeschlossen ist und dessen der Serienschaltung abgewandte Hauptelektrode über einen Abtast-Transistor Tnz (nämlich Tnzij in FIG. 2 bzw. Tnzj in FIG 3 bzw. Tnzi in FIG 4) mit dem einen Anschluß U $_{SS}$ (Masse) der Betriebsspannungsquelle verbunden ist; mit dem anderen Anschluß U $_{DD}$ der Betriebsspannungsquelle ist die jeweilige Matrixausgangsleitung (Zeilenleitung) ...zi... über einen Vorlade-Transistor Tpi verbunden. Dabei kann, wie dies auch FIG 2 verdeutlicht, jeweils ein koppelelement-individueller Abtast-Transistor Tnzij vorgesehen sein; alternativ kann aber auch, wie dies FIG 3 zeigt, jeweils für alle an ein und derselben Matrixeingangsleitung (Spaltenleitung) ...sj... liegende Koppelelemente ein gemeinsamer und damit matrixeingangsleitungs-individueller Abtast-Transistor (Tnzj in FIG 3) vorgesehen sein, oder es kann, wie die aus FIG 4 ersichtlich ist, jeweils ein allen an ein und derselben Matrixausgangsleitung (Zeilenleitung) ...zi... liegenden Koppelelementen gemeinsamer und damit matrixausgangsleitungs-individueller Abtast-Transistor (Tnzi in FIG 4) vorgesehen sein.

Wie dies auch in FIG 2 bis FIG 4 angedeutet ist, können - bei in CMOS-Technik gehaltener Koppelpunktmatrix - die Schalter-Transistoren Tnk, die Vorschalt-Transistoren Tne und Abtast-Transistoren Tnz n-Kanal-Transistoren sein und die Vorlade-Transistoren Tpi p-Kanal-Transistoren.

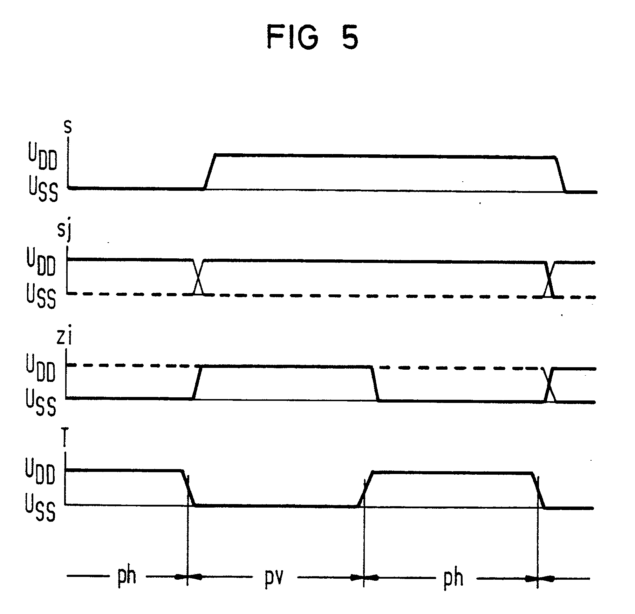

Vorlade-Transistoren Tpi und Abtast-Transistoren Tnz sind gegensinnig zueinander jeweils an ihrer Steuerelektrode mit einem eine Bit-Durchschaltezeitspanne in in FIG 5, unten, angedeuteter Weise in eine Vorphase pv und eine Hauptphase ph unterteilenden Takt T beaufschlagt, wie er in FIG 5 in Zeile T angedeutet ist.

Während der Vorphase pv (siehe FIG 5, unten) werden die Matrixausgangsleitungen (Zeilenleitungen) ...zi... über den jeweiligen Vorlade-Transistor (Tpi in FIG 2 bis FIG 4) zumindest angenähert auf das $U_{DD}$-Betriebspotential geladen, wozu die beispielsweise durch p-Kanal-Transistoren gebildeten Vorlade-Transistoren Tpi im Beispiel durch ein "Low"-Taktsignal T (siehe FIG 5, Zeile T) leitend gemacht werden. Zugleich werden die durch n-Kanal-Tra nsistoren gebildeten Abtast-Transistoren Tnz (Tnzij in FIG 2, Tnzj in FIG 3, Tnzi in FIG 4) im Beispiel durch das gleiche "Low"-Taktsignal T im entgegengesetzten Sinne ausgesteuert, d.h. gesperrt, so daß die Auflage der Matrixausgangsleitungen (Zeilenleitungen) ...zi... unabhängig von der Ansteuerung des jeweiligen Schalter-Transistors Tnk (in FIG 2 bis FIG 4) und des jeweiligen Vorschalt-Transistors Tne (in FIG 2 bis FIG 4) der einzelnen Koppelelemente ...Kij... vor sich gehen kann. Auf der jeweiligen Matrixeingangsleitung (Spaltenleitung) ...sj... kann sich dabei ggf. schon das dem jeweils durchzuschaltenden Bit entsprechende Potential aufbauen (bzw. beibehalten werden), wie dies auch in FIG 5 in Zeile sj angedeutet ist.

In der darauffolgenden Hauptphase ph (siehe FIG 5, unten), werden im Beispiel durch ein "High"-Taktsignal T (siehe FIG 5, Zeile T) die Vorlade-Transistoren Tpi (in FIG 2 bis FIG 4) gesperrt und zugleich die Abtast-Transistoren Tnz (Tnzij in FIG 2, Tnzj in FIG 3, Tnzi in FIG 4) entriegelt. Ist nun in einem Koppelelement ...Kij... dessen im Beispiel durch einen n-Kanal-Transistor gegebener Schalt-Transistor Tnk (in FIG 2 bis FIG 4) aufgrund eines am Steuereingang s anliegenden (im Beispiel "High"-)Durchschaltesignals (siehe FIG 5, Zeile s) leitend und befindet sich damit der Koppelpunkt im Zuschaltezustand, so wird jetzt je nach dem dem durchzuschaltenden Bit entsprechenden, auf der betreffenden Matrixeingangsleitung (Spaltenleitung) ...sj... herrschenden Signalzustand die mit dieser Matrixeingangsleitung (Spaltenleitung) ... sj... über das betreffend Koppelelement ..Kij.. verbundene Matrixausgangsleitung (Zeilenleitung) ...zi... entladen werden oder auf dem in der Vorphase pv angenommenen $U_{DD}$-Potential verbleiben:

Herrscht auf der betreffenden Matrixeingangsleitung (Spaltenleitung) sj der "Low"-Signalzustand, wie dies in FIG 5, Zeile sj, mit einer gestrichelten Linie angedeutet ist, und ist dementsprechend der (n-Kanal-)Vorschalt-Transistor Tne (in FIG 2 bis FIG 4) des betreffenden Koppelelements Kij gesperrt, so wird die betreffende Matrixausgangsleitung (Zeilenleitung) zi über dieses Koppelelement Kij nicht entladen, sondern behält unter der Voraussetzung, daß kein anderer zu dieser Matrixausgangsleitung (Zeilenleitung) zi führender Koppelpunkt sich im Durchschaltezustand befindet, den $U_{DD}$-Potentialzustand bei.

Herrscht dagegen auf der gerade betrachteten Matrixeingangsleitung (Spaltenleitung) sj der "High"-Signalzustand, wie dies in FIG 5, Zeile sj, mit einer durchgezogenen Linie angedeutet ist, und ist dementsprechend der Vorschalt-Transistor Tne (in FIG 2 bis FIG 4) des betrachteten Koppelelements Kij ebenso wie der Schaltertransistor Tnk und der zugehörige Abtast-Transistor Tnz leitend, so wird die Matrixausgangsleitung (Zeilenleitung) zi über dieses Koppelelement Kij entladen und auf das $U_{SS}$-Potential gezogen.

Über einen von seinem Steuereingang s her entriegelten Koppelpunkt wird somit das jeweilige Eingangssignal jeweils invertiert durchgeschaltet.

In den im vorstehenden anhand von FIG 2 bis FIG 4 erläuterten Ausführungsbeispielen sind die Vorlade-Transistoren (Tpi) durch p-Kanal-Transistoren gebildet, wobei diese p-Kanal-Vorlade-Transistoren (Tpi) und die durch n-Kanal-Transistoren gebildeten Abtast-Transistoren (Tnz), durch den unterschiedlichen Kanaltypus bedingt, durch ein und dasselbe Signal (T) gegensinnig zueinander gesteuert werden. In Abweichung hiervon ist es aber auch möglich, die Vorlade-Transistoren mit n-Kanal-Transistoren zu realisieren, so daß wenn auch die Schalter-Transistoren (Tnk), die Vorschalt-Transistoren (Tne) und die Abtast-Transistoren (Tnz) n-Kanal-Transistoren sind, nur Transistoren ein und des selben Kanaltyps zur Anwendung kommen; damit dann Vorlade-Transistoren und Abtast-Transistoren wiederum gegensinnig zueinander jeweils an ihrer Steuerelektrode mit dem Koppelfeld-Ansteuer-Takt beaufschlagt werden, ist den Abtast-Transis toren (Tnz) wiederum, wie in den anhand von FIG 2 bis FIG 4 beschriebenen Ausführungsbeispielen, das Koppelfeld-Ansteuer-Taktsignal (T) direkt zuzuführen, den (n-Kanal-)Vorlade-Transistoren dagegen das invertierte Koppelfeld-Ansteuer-Taktsignal.

Abschließend sei noch folgendes bemerkt:

In der in FIG 1 skizzierten Breitbandsignal-Koppeleinrichtung werden in den einzelnen Koppelpunkten ...Kpij... deren Koppelelemente ...Kij... an ihren Steuereingängen s von koppelpunktindividuellen (Halte-)Speicherelementen ...Hij... gesteuert, die ihrerseits von außerhalb der eigentlichen Koppelpunktmatrix liegenden Adressendecodern gezielt angesteuert werden. Eine solche (im Prinzip bekannte) Ansteuerung der Koppelpunkte ist insbesondere dann von Vorteil, wenn der jeweilige Sperr- bzw. Durchschalte-Zustand eines Koppelpunktes verhältnismäßig lange beibehalten und verhältnismäßig selten geändert wird, wie dies insbesondere bei der Vermittlung von sog. Verteildiensten der Fall sein mag.

Die Erfindung ist indessen nicht an eine solche Ansteuerung der Koppelpunkte gebunden; in Abweichung von der Darstellung in FIG 1 ist es vielmehr auch möglich, die zur Koppelpunktansteuerung erforderlichen Halte-Speicherschaltungen als Adressenregister extern, d.h. außerhalb der eigentlichen Koppelpunktmatrix, anzuordnen und die zur Koppelpunktansteuerung erforderlichen Adressendecoder in Form von koppelpunktindividuellen Decoderelementen (Verknüpfungsgliedern) in die Koppelpunktmatrix zu integrieren. Eine solche im Prinzip ebenfalls (z.B. aus Kunze: "TIDES: A New Concept In Time Division Electronic Switching", Communications présentées au COLLOQUE INTERNATIONAL de COMMUTATION ÉLECTRONIQUE, Paris 1966, ÉDITIONS CHIRON, Seiten 301...312) bekannte Ansteuerung der Koppelpunkte ist insbesondere dann zweckmäßig, wenn der jeweilige Sperr- bzw. Durchschalte-Zustand eines Koppelpunktes jeweils nur verhältnismäßig kurz beibehalten und verhältnismäßig häufig geändert wird, wie dies insbesondere bei einer bitweisen Vermittlung von Dialogdiensten der Fall sein mag.

**Ansprüche**

1. Breitbandsignal-Koppeleinrichtung mit einer Koppelpunkt-Matrix in FET-Technik, deren Koppelelemente (Kij) jeweils mit einem an seiner Steuerelektrode (5) mit einem Durchschalte-bzw. Sperrsignal beaufschlagten, mit einer Hauptelektrode an die zugehörige Matrixausgangsleitung (zi) angeschlossenen Schalter-Transistor (Tnk) gebildet sind, **dadurch gekennzeichnet,** daß die Koppelelemente (Kij) jeweils einen mit dem Schalter-Transistor (Tnk) eine Serienschaltung bildenden Vorschalt-Transistor (Tne) aufweisen, der mit seiner Steuerelektrode an die zugehörige Matrixeingangsleitung (sj) angeschlossen ist und dessen der Serienschaltung abgewandte Hauptelektrode über einen Abtast-Transistor (Tnz) mit dem einen Anschluß (U SS, Masse) der Betriebsspannungsquelle verbunden ist, mit deren anderen Anschluß (U DD) die jeweilige Matrixausgangsleitung (zi) über einen Vorlade-Transistor (Tpi) verbunden ist, und daß Vorlade-Transistor (Tpi) und Abtast-Transistor (Tnz) gegensinnig zueinander jeweils an ihrer Steuerelektrode mit einem eine Bit-Durchschaltezeitspanne in eine Vorladephase (pv) und die eigentliche Durchschaltephase (ph) unterteilenden Koppelfeld-Ansteuer-Takt (T) beaufschlagt sind, so daß in jeder Vorphase (pv) bei gesperrtem Abtast-Transistor (Tnz) die Matrixausgangsleitung (zi) über den Vorlade-Transistor (Tpi) zumindest angenähert auf das an dem genannten anderen Anschluss (U DD) der Betriebsspannungsquelle herrschende Potential geladen wird.

2. Breitbandsignal-Koppeleinrichtung nach Anspruch 1, **dadurch gekennzeichnet,** daß die Schalter-Transistoren (Tnk), die Vorschalt-Transistoren (Tne) und die Abtast-Transistoren (Tnz) n-Kanal-Transistoren und die Vorlade-Transistoren (Tpi) p-Kanal-Transistoren sind.

3. Breitbandsignal-Koppeleinrichtung nach Anspruch 1, **dadurch gekennzeichnet,** daß sowohl die Schalter-Transistoren (Tnk), die Vorschalt-Transistoren (Tne) und die Abtast-Transistoren (Tnz) als auch die Vorlade-Transistoren n-Kanal-Transistoren sind.

4. Breitbandsignal-Koppeleinrichtung nach einem der Ansprüche 1 bis 3, **dadurch gekennzeichnet,** daß jeweils ein koppelelement-individueller Abtast-Transistor (Tnzij) vorgesehen ist.

5. Breitbandsignal-Koppeleinrichtung nach einem der Ansprüche 1 bis 3, **dadurch gekennzeichnet,** daß jeweils ein matrixeingangsleitungs-individueller Abtast-Transistor (Tnzj) vorgesehen ist.

6. Breitbandsignal-Koppeleinrichtung nach einem der Ansprüche 1 bis 3, **dadurch gekennzeichnet,** daß jeweils ein matrixausgangsleitungs-individueller Abtast-Transistor (Tnzi) vorgesehen ist.

**Claims**

1. Switching device for broadband signals comprising a switching-point matrix in FET technology, the switching elements of which (Kij) are in each case formed by means of a switch transistor (Tnk), to the control electrode (s) of which a connecting-through or blocking signal is applied and a main electrode of which is connected to the associated matrix output line (zi), characterised in that the switching elements (Kij) in each case exhibit an auxiliary transistor (Tne) forming a series circuit with the switch transistor (Tnk), which auxiliary transistor is connected with its control electrode to the associated matrix input line (sj) and the main electrode of which, which faces away from the series circuit, is connected via a sampling transistor (Tnz) to one terminal (U$_{SS}$, earth) of the operating voltage source, to the other terminal of which (U$_{DD}$) is connected the respective matrix output line (zi) via a pre-charging transistor (Tpi) and that in each case to the control electrode of the precharging transistor (Tpi) and the sampling transistor (Tnz) in opposite directions to one another a switching matrix drive clock (T) is applied which subdivides a bit through-connecting period into a pre-charging phase (pv) and the actual through-connection phase (ph) so that in each pre-phase (pv) when the sampling transistor (Tnz) is blocked, the matrix output line (zi) is at least approximately charged via the pre-charging transistor (Tpi) to the potential prevailing at the said other terminal (U$_{DD}$) of the operating voltage source.

2. Switching device for broadband signals according to Claim 1, characterised in that the switch transistors (Tnk), the auxiliary transistors (Tne) and the sampling transistors (Tnz) are n-channel transistors and the precharging transistors (Tpi) are p-channel transistors.

3. Switching device for broadband signals according to Claim 1, characterized in that both the switch transistors (Tnk), the auxiliary transistors (Tne) and the sampling transistors (Tnz) as well as the precharging transistors are n-channel transistors.

4. Switching device for broadband signals according to one of Claims 1 to 3, characterised in that in each case a switching-element-individual sampling transistor (Tnzij) is provided.

5. Switching device for broadband signals according to one of Claims 1 to 3, characterised in that in each case a matrix-input-line-individual sampling transistor (Tnzj) is provided.

6. Switching device for broadband signals according to one of Claims 1 to 3, characterized in that in each case a matrix-output-line-individual sampling transistor (Tnzi) is provided.

**Revendications**

1. Dispositif de couplage pour des signaux à large bande comportant une matrice de points de couplage réalisée selon la technique FET, dont les éléments de couplage (Kij) sont formés chacun d'un transistor-interrupteur (Tnk), chargé, au niveau de son électrode de commande (S), par un signal d'interconnexion ou de blocage, et raccordé, par une électrode principale, au conducteur de sortie associé (zi) de la matrice,
caractérisé par le fait
que les éléments de couplage (Kij) possèdent chacun un transistor additionnel (Tne) qui forme un circuit série avec le transistor-interrupteur (Tnk) et est raccordé, par son électrode de commande, au conducteur d'entrée associé (sj) de la matrice et dont l'électrode principale, située à l'opposé du circuit série, est raccordée par l'intermédiaire d'un transistor d'exploration (Tnz) à une borne (U$_{SS}$, masse) de la source de tension d'alimentation, à l'autre borne (U$_{DD}$) de laquelle est raccordé le conducteur de sortie respectif (zi) de la matrice, par l'intermédiaire d'un transistor de précharge (Tpi), et
que le transistor de précharge (Tpi) et le transistor d'exploration (Tnz) sont chargés, en des sens réciproquement opposés, et ce respectivement au niveau de leur électrode de commande, par une cadence (T) de commande du champ de couplage, qui subdivise un intervalle de temps de transmission des bits en une phase de précharge (pv) et en la phase proprement dite de transmission (ph), de sorte que pendant chaque phase de précharge (pv), lorsque le transistor d'exploration (Tnz) est bloqué, le conducteur de sortie (zi) de la matrice est chargé, par l'intermédiaire du transistor de précharge (Tpi), au moins approximativement au potentiel régnant sur ladite autre borne (U$_{DD}$) de la source de tension de service.

2. Dispositif de couplage pour signaux à large bande suivant la revendication 1, caractérisé par le fait que les transistors-interrupteurs (Tnk), les transistors additionnels (Tni) et les transistors d'exploration (Tnz) sont des transistors à canal n et que les transistors de précharge (Tpi) sont des transistors à canal p.

3. Dispositif de couplage pour signaux à large bande suivant la revendication 1, caractérisé par le fait qu'aussi bien les transistors-interrupteurs (Tnk), les transistors additionnels (Tni) et les transistors d'exploration (Tnz) et également les transistors de précharge sont des transistors à canal n.

4. Dispositif de couplage pour signaux à large bande suivant l'une des revendications 1 à 3, caractérisé par le fait qu'il est prévu respectivement un transistor d'exploration (Tnzij) pour chaque élément de couplage.

5. Dispositif de couplage pour signaux à large bande suivant l'une des revendications 1 à 3, caractérisé par le fait qu'il est prévu respectivement un transistor d'exploration (Tnzj) pour chaque conducteur d'entrée de la matrice.

6. Dispositif de couplage pour signaux à large bande suivant l'une des revendications 1 à 4, caractérisé par le fait qu'il est prévu respectivement un transistor d'exploration (Tnzi) pour chaque conducteur de sortie de la matrice.

# FIG 1

FIG 2

FIG 3

FIG 4

# FIG 5